# EUROPÄISCHE PATENTSCHRIFT

(11) **EP 1 658 615 B1**
(45) Veröffentlichungstag und Bekanntmachung des Hinweises auf die Patenterteilung: **14.10.2009**
(21) Anmeldenummer: 03747934.2
(22) Anmeldetag: 27.08.2003
(51) Int. Cl.: G11C 11/22, G03F 7/20

(54) **SCHIEFSPIEGLIGES NORMAL-INCIDENCE-KOLLEKTORSYSTEM FÜR LICHTQUELLEN, INSBESONDERE EUV-PLASMAENTLADUNGSQUELLEN**
OBLIQUE REFLECTOR NORMAL INCIDENCE COLLECTOR SYSTEM FOR LIGHT SOURCES, IN PARTICULAR FOR EUV PLASMA DISCHARGE SOURCES
SYSTEME COLLECTEUR A INCIDENCE NORMALE ET A REFLEXION OBLIQUE POUR DES SOURCES LUMINEUSES, EN PARTICULIER DES SOURCES À PLASMA DE DÉCHARGE DANS L'UV EXTRÊME

(43) Veröffentlichungstag der Anmeldung: 24.05.2006
(73) Patentinhaber: Carl Zeiss SMT AG, 73447 Oberkochen (DE)
(72) Erfinder: SINGER, Wolfgang, 73431 Aalen (DE)
(74) Vertreter: Sawodny, Michael-Wolfgang
(86) Internationale Anmeldenummer: PCT/EP2003/009466
(87) Internationale Veröffentlichungsnummer: WO 2005/031748

(56) Entgegenhaltungen:
- DE-A1- 19 903 807
- US-B1- 6 438 199

## Beschreibung

Die Erfindung betrifft ein schiefspiegliges normal-incidence-Kollektorsystem, insbesondere für Lichtquellen, die überwiegend Strahlung mit Wellenlängen ≤193 nm emittieren. Ganz besonderes bevorzugt sind EUV-Lichtquellen, insbesondere EUV-Plasmaentladungsquellen. Die Erfindung beschreibt des Weiteren ein Beleuchtungssystem umfassend ein derartiges Kollektorsystem, das bevorzugt einer EUV-Projektionsbelichtungsanlage, insbesondere für die EUV-Lithographie, zugeordnet ist.

Um die Strukturbreiten für elektronische Bauteile noch weiter reduzieren zu können, insbesondere in den Submikron-Bereich, ist es erforderlich, die Wellenlänge des für die Mikrolithographie eingesetzten Lichtes zu verringern. Denkbar ist die Verwendung von Licht mit Wellenlängen ≤193 nm, beispielsweise die Lithographie mit weichen Röntgenstrahlen, die so genannte EUV-Lithographie.

Die EUV-Lithographie ist eine der vielversprechendsten zukünftigen Lithographietechniken. Als Wellenlängen für die EUV-Lithographie werden derzeit Wellenlängen im Bereich 11 - 14 nm, insbesondere 13,5 nm, diskutiert bei einer numerischen Apertur von 0,2 -0,3. Die Bildqualität in der EUV-Lithographie wird bestimmt einerseits durch das Projektionsobjektiv, andererseits durch das Beleuchtungssystem. Das Beleuchtungssystem soll eine möglichst gleichförmige Ausleuchtung der Feldebene, in der die strukturtrageride Maske, das so genannte Retikel, angeordnet ist, zur Verfügung stellen. Das Projektionsobjektiv bildet die Feldebene in eine Bildebene, die so genannte Waferebene, ab, in der ein lichtsensitives Objekt angeordnet ist. Projektionsbelichtungsanlagen für die EUV-Lithographie sind mit reflektiven optischen Elementen ausgeführt. Die Form des Feldes einer EUV-Projektionsbelichtungsanlage ist typischerweise die eines Ringfeldes mit einem hohen Aspektverhältnis von 2 mm (Breite) x 22 - 26 mm (Bogenlänge). Die Projektionssysteme werden üblicherweise im Scanning Mode betrieben, wobei das Retikel in der Feldebene und das lichtempfindliche Objekt, typischerweise ein Wafer, mit einem geeigneten Photoresist in der Bildebene jeweils synchron zueinander bewegt werden. Betreffend EUV-Projektionsbelichtungsanlagen wird auf die nachfolgenden Veröffentlichungen verwiesen:
W.Ulrich, S.Beiersdörfer, H.J.Mann, "Trends in Optical Design of Projection Lenses for UV- and EUV-Lithography" in Soft-X-Ray and EUV Imaging Systems, W.M.Kaiser, R.H.Stulen (Hrsg), Proceedings of SPIE, Vol.4146 (2000), Seiten 13-24 und
M.Antoni, W.Singer, J.Schultz, J.Wangler, I.Escudero-Sanz, B.Kruizinga, "Illumination Optics Design for EUV-Lithography" in Soft X Ray and EUV Imaging Systems, W.M.Kaiser, R.H.Stulen (Hrsg), Proceedings of SPIE, Vol.4146 (2000), Seiten 25-34

Zur Aufnahme der Strahlung von EUV-Lichtquellen, insbesondere von Laser-Plasma-Quellen und von Entladungsquellen, werden nach dem derzeitigen Stand der Technik grazing-incidence Kollektoren eingesetzt, also solche, bei denen die EUV-Strahlung im streifenden Einfall unter Ausbildung einer Totalreflektion auf die reflektiven Flächen trifft. Solche Kollektoren können beispielsweise als genestete Systeme ausgeführt werden, welche aus mehreren Kollektorschalen zusammengesetzt sind und an welchen jeweils zwei Reflektionen stattfinden. Solche genesten Kollektoren werden auch als Woltersysteme bezeichnet. Bei einem derartigen Kollektorsystem kommen Spiegelsysteme zum Einsatz, die beispielsweise aus einer Kombination hyperboloidförmiger und ellipsoidförmiger Spiegel bestehen und deren Prinzip in der Literatur erstmalig in den Annalen der Physik 10, 94 - 114, 1952 genannt ist.

Der Vorteil dieser Art von Kollektoren besteht darin, dass auch von großbauenden Lichtquellen, wie beispielsweise Discharge-Quellen, die in den Halbraum abgestrahlte Leistung aufgenommen und in Vorwärtsrichtung gebündelt wird. Eine entsprechende Ausführung ist aus der US 5 763 930 bekannt. Dafür wird in Kauf genommen, dass eine die Maße des Beleuchtungssystems reduzierende Rückfaltung des Strahlengangs in der Nähe der Lichtquelle mit diesem Prinzip nicht möglich ist, zumal nach dem gegenwärtigen Stand der Technik einer solchen Rückfaltung die Ausdehnung der Lichtquelle entgegensteht.

Ein weiterer Nachteil der grazing-incidence Kollektoren sind Verschattungseffekte, die durch die unvermeidlichen mechanischen Halterungen insbesondere bei einem genesteten Aufbau entstehen. Diese können zwar filigran, z.B. in Form eines Speichenrads aufgebaut sein, dennoch führen sie vor allem bei kleinen Quellen zu Strahlungsverlusten. Eine entsprechende Problematik ergibt sich für Kühleinrichtungen des grazing-incidence Kollektors, die ebenfalls die mechanischen Strukturen verdicken und somit zu den Abschattungsverlusten betragen. Hierbei kann auf derartige Kühleinrichtungen deshalb nicht verzichtet werden, da für die Lithographie bei 13,5 nm aufgrund der Notwendigkeit ein Vakuum auszubilden, kein ausreichender Wärmeübertrag vorhanden ist und so die thermische Belastung zu einer nicht tolerierbaren Verformung der Spiegelschalen führen würde.

Kollektoren mit einem einzelnen normal-incidence Kollektorspiegel, wie sie beispielsweise aus der EP 1 255 163 bekannt geworden sind, können zwar rückseitig gut gekühlt werden, jedoch ist eine Abschattung, die sich durch die endliche Ausdehnung der Lichtquelle ergibt, nicht zu vermeiden. Liegt keine Laser-Plasma-Quelle, sondern eine Entladungsquelle vor, so führt der Platzbedarf, der sich durch die ausgedehnten Elektroden ergibt, zu einer starken Verringerung der Beleuchtungsleistung. Zur Umgehung dieses Problems kann eine weitere Rückfaltung in der Nähe der Quelle vorgenommen werden. Solche Kollektoren, die aus zwei in der Form eines Schwarzschild-Systems angeordneten normal-incidence Spiegeln bestehen, sind aus der US 5 737 137 bekannt geworden und werden auch in der EP 1 319 988 A2 zur individuellen Fokussierung von EUV-Lichtquellen in einer Mehrfachlichtquellenanordnung vorgeschlagen. Dabei ist es aus Platzgründen nicht möglich, nach der Lichtquelle einen Partikelfilter anzuordnen, was insbesondere zu einer schnellen Verschmutzung der quellnahen normal-incidence Spiegel führt. Außerdem sind die aus dem Stand der Technik bekannten Kollektoren mit Schwarzschild-Anordung durch gekennzeichnet, dass die von der EUV-Lichtquelle ausgehende Strahlung vom ersten normal-incidence Kollektorspiegel mit einer kleinen numerischen Apertur von typischerweise NA - 0,3 aufgenommen wird. Beim Übergang zu größeren Kollektionswinkeln in einem solchen System vergrößern sich die Einfallswinkel auf dem zweiten Kollektorspiegel gegenüber der Flächennormale, was eine verminderte Reflektivität und eine verstärkt polarisierende Wirkung der Vielschicht-Reflektionsbeschichtung nach sich zieht. Aus der DE 19903807 A1 ist ein Kollektorsystem, das Symmetrisch zu einer optischen Achse aufgebaut ist mit zwei Kollektorspiegeln bekannt geworden.

In einer Ausführungsform des Kollektorsystems ist erste Kollektorspiegel ein konkaver normal-incidence Spiegel, der Strahlung mit einer Na ≥ 0.5 aufnimmt, während in einer zweiten Ausführungsform der zweite Kollektorspiegel in einem Lotabstand zur Geraden, die durch die Lichtquelle und den Scheitelpunkt des ersten Kollektorspiegels geht, positioniert ist.

Die Aufgabe der Erfindung besteht darin, ein Kollektorsystem bestehend aus normal-incidence Spiegeln für eine Lichtquelle, insbesondere eine EUV-Lichtquelle, wobei hierfür besonders Laser-Plasma- oder Entladungslichtquellen bevorzugt werden, derart zu gestalten, dass die eingangs dargestellten Probleme des Stands der Technik überwunden werden. Dabei sollte insbesondere ein gut zu kühlendes Kollektorsystem angegeben werden, das die Strahlung der Lichtquelle mit einer großen numerischen Apertur und damit einer hohen Kollektionsapertur aufnimmt sowie gleichzeitig geringe Strahlungsverluste und möglichst kleine Einfallswinkel auf den Vielschichtreflektionsschichten der Spiegel des Kollektors ermöglicht. Das Köllektorsystem soll ferner einen ausreichenden Bauraum für die Abschirmung der Lichtquelle zur Verfügung stellen und zu einer möglichst kurzen Gesamtlänge des Beleuchtungssystems beitragen sowie eine spektral reine Beleuchtungsstrahlung erzeugen.

Die Aufgabe der Erfindung wird durch Anspruch 1 gelöst.

Die Erfinder haben erkannt, dass es bei einem Kollektorsystem aus zwei normal-incidence Spiegeln durch einen schiefspiegligen Aufbau eines Schwarzschild-Systems gelingt, eine hohe Kollektionsapertur mit hinreichend kleinen Einfallswinkeln zu verbinden. Unter der Kollektionsapertur wird in der vorliegenden Anmeldung die vom ersten Kollektorspiegel aufgenommene numerische Apertur verstanden, diese wird nachfolgend als erste numerische Apertur, der ein erster Aperturwinkel zugeordnet ist, bezeichnet. Hierzu wird ein erfindungsgemäßes Kollektorsystem so gestaltet, dass die von einem ersten normal-incidence Spiegel zurückgefaltete numerische Apertur kleiner oder gleich groß der Kollektionsapertur ist. Hieraus ergibt sich ein Anwachsen der Spiegelgröße des zweiten normal-incidence Spiegels, der wiederum in einem Abstand zum ersten normal-incidence Spiegel positioniert ist, welcher möglichst dem Queltabstand angenähert wird. Erfindungsgemäß gelingt dies durch einen nicht-symmetrischen Aufbau, d.h. schiefspiegligen Aufbau des Kollektors. Darunter wird verstanden, dass die Axialsymmetrie des Kollektors aufgegeben wird. Hierbei wird der zweite normal-incidence Spiegel im Wesentlichen neben der Lichtquelle positioniert. Hierdurch wird genügend Bauraum für das Einschließen der Lichtquelle in ein eigenes Kompartiment geschaffen und zugleich kann der zweite normal-incidence Spiegel entsprechend vergrößert ausgebildet und in einem hinreichenden Abstand zum ersten normal-incidence Spiegel positioniert werden. Außerdem ist bei einer solchen Anordnung die rückseitige Kühlung der Spiegelelemente auf einfache Art und Weise durchführbar.

In einer vorteilhaften Ausgestaltung der Erfindung werden zumindest der erste normal-incidence Spiegel durch die Hinzunahme von konischen Anteilen bei der Ausformung an die außeraxiale Positionierung des zweiten normal-incidence Spiegels angepasst. Konische Anteile in der Ausgestaltung können auch lediglich für einen dieser Spiegel angewandt werden.

Die Erfindung soll nachfolgend anhand der Zeichnungen beispielhaft beschrieben werden.

Es zeigen:
- Fig. 1: den Aufbau eines Lithographiesystems mit einem erfindungsgemäßen schiefspiegligen Schwarzschild-Kollektorsystem;
- Fig. 2: den Aufbau eines Lithographiesystems mit einem dem Stand der Technik entsprechenden axialsymmetrischen Schwarzschild- Kollektorsystem;
- Fig. 3: einen schiefspiegligen Schwarzschild-Kollektorsystem mit einem einstellbaren zweiten normal-incidence Spiegel;
- Fig. 4 a-c: die Ausgestaltung eines schiefspiegligen Schwarzschild-Kollektors mit konischen Anteilen für die Ausformung der Spiegelflächen.

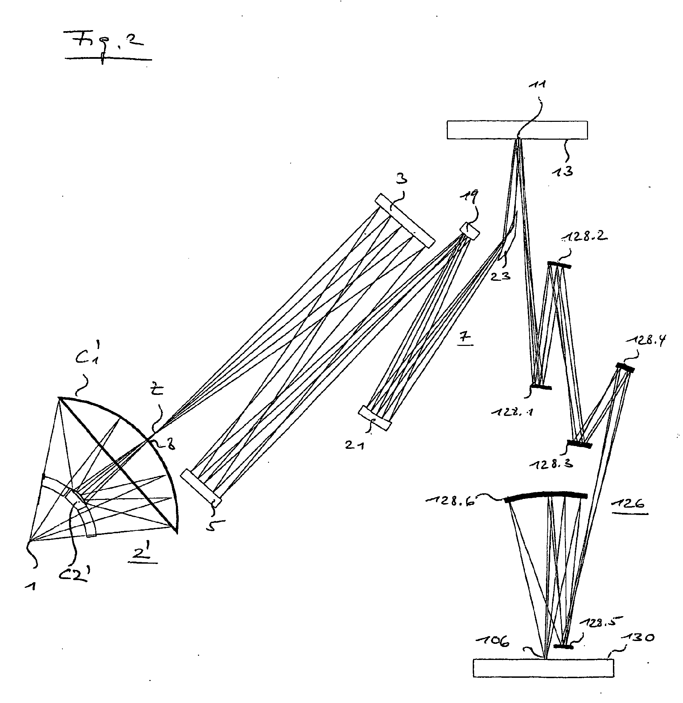

In Figur 2 wird der typische Aufbau eines EUV-Lithographiesystems für die Mikrolithographie dargestellt, welches ein dem Stand der Technik entsprechendes Schwarzschild-Kollektorsystem 2' umfasst.

Die schematisch vereinfachte Darstellung des Schwarzschild-Kollektorsystems 2' zeigt einen ersten normal-incidence Kollektorspiegel C1', der durch seine konkave, beispielsweise parabolische oder elliptische Ausformung Licht von der Lichtquelle 1 aufnimmt und auf den zweiten normal-incidence Kollektorspiegel C2' zurückfaltet, der wiederum hyperbolisch oder ellipsoidförmig ausgebildet sein kann. Dieser zweite normal-incidence Kollektorspiegel C2' ist so zentriert zum ersten normal-incidence Kollektorspiegel C1' angeordnet, dass ein symmetrisches Kollektorsystem entsteht, welches die Lichtquelle 1 auf ein vergrößertes Zwischenbild Z abbildet. Für die vom zweiten normal-incidence Kollektorspiegel C2' ausgehende Strahlung ist ein Durchgang 8 im ersten normal-incidence Kollektorspiegel C1' vorgesehen. Demnach wird vom ersten normal-incidence Kollektorspiegel C1' Licht von der Lichtquelle 1 mit einem ersten Aperturwinkel aufgenommen und mit einem zweiten Aperturwinkel zum zweiten normal-incidence Kollektorspiegel C2' abgestrahlt. Dem vom zweiten normal-incidence Kollektorspiegel C2' ausgehende Strahlbüschel wird wiederum ein dritter Aperturwinkel zugeordnet. Unter Aperturwinkel wird in der vorliegenden Anmeldung der Winkel zwischen dem Randstrahl eines Strahlenbüschels mit dem maximalen Strahlwinkel zur optischen Achse verstanden. Bei den bei EUV-Beleuchtung vorliegenden Vakuumbedingungen ergibt sich dann die numerische Apertur aus dem Sinus des Aperturwinkels.

Die Aufgabe des Kollektorsystems ist es, von der Quelle einen großen ersten Aperturwinkel aufzunehmen, beispielsweise von 45°, und in einen wesentlich kleineren dritten Aperturwinkel von beispielsweise 6° hinter dem Kollektorsystem umzuwandeln, wobei der dritte Aperturwinkel an das nachfolgende Beleuchtungssystem angepasst ist. Beispielsweise führt ein halber Öffnungswinkel oder erster Aperturvvinkel von 45° am ersten normal-incidence Kollektorspiegel C1' zu einem dritten Aperturwinkel von 6° am zweiten normal-incidence Kollektorspiegel C2' und damit zu einer Reduktion der numerischen Apertur von etwa NA - 0,7 auf etwa NA - 0,1 entsprechend einem Abbildungsmaßstab des Kollektors von etwa 7.

Der zweite normal-incidence Kollektorspiegel C2' muss aufgrund der Zurückfaltung des Strahlengangs notwendigerweise klein ausgebildet und in einem gewissen Abstand zur Lichtquelle 1 positioniert werden. Hieraus ergibt sich der Nachteil, dass der zweite Aperturwinkel des Strahlenganges nach dem ersten normal-incidence Kollektorspiegels C1' größer sein muss, als der durch den ersten normal-incidence-Kollektorspiegel von der Quelle aufgenommene erste Aperturwinkel. Im vorliegenden Beispiel beträgt die Schnittweite zwischen Quelle und erstem Kollektorspiegel C1' 450mm; die Schnittweite zwischen erstem . Kollektorspiegel C1' und virtuellem Zwischenbild der Quelle (nicht eingezeichnet in Figur 2) beträgt 280mm, woraus der Abbildungsmaßstab auf 280mm / 450mm = 0.622 abgeschätzt werden kann, d.h. der Sinus des zweiten Aperturwirikels ist um etwa 1/0.622 = 1.61 mal größer als der Sinus des ersten Aperturwinkels. Bereits ein kleiner erster Aperturwinkel von nur 38° führt in diesem Fall zu einem zweiten Aperturwinkel von 90°. Dieser große zweite Aperturwinkel muss durch den zweiten normal-incidence Kollektorspiegel C2' in den wesentlich kleineren, vom zweiten normal-incidence Kollektorspiegel C2' ausgehenden dritten Aperturwinkel umgewandelt werden. Bei einer realen Auslegungen von normal-incidence-Kollektoren stellt man fest, dass sich Abweichungen von der Sinusbedingung bei der Abbildung der Lichtquelle durch die Kollektorspiegel C1' und C2' ergeben. Gleichwohl gibt die obige Abschätzung die grundlegende Problematik richtig wieder.

Dieser nachteilige Effekt wird bei Betrachtung eines vom ersten normal-incidence Kollektorspiegel C1' ausgehenden Randstrahls in Figur 2 deutlich, der den ersten Aperturwinkel von etwa 38°, was einer Kollektionsapertur von ungefähr 0,6 entspricht, begrenzt. Für den zweiten Aperturwinkel, gegeben durch den Randstrahl der vom ersten normal-incidence Kollektorspiegel abgestrahlt wird, folgt eine Winkel von etwa 60°, welcher, wie oben ausgeführt, bei zweispiegligen normal-incidence-Kollektoren nach dem Stand der Technik erheblich größer als der erste Aperturwinkel ist. Am zweiten normal-incidence Kollektorspiegel C2' wird also der Randstrahl mit zweitem Aperturwinkel von 60° zum Randstrahl mit drittem Aperturwinkel von -6° umgelenkt, wobei die Winkel sich jeweils auf den Strahlwinkel zur Symmetrieachse beziehen. Somit entsteht gegenüber der Spiegelfläche des zweiten normal-incidence Kollektorspiegels C2' ein großer Einfallswinkel von 33°, so dass eine Verringerung der Reflektivität der Spiegeloberfläche sowie unerwünschte Polarisationseffekte auftreten.

Aus der Förderung der voranstehend genannten Reduktion der numerischen Apertur vom ersten auf den dritten Aperturwinkel ergibt sich folglich aus dem Stand der Technik der Nachteil, dass der erste Aperturwinkel und damit die von der Lichtquelle aufnehmbare Leistung begrenzt ist, da der zweite Aperturwinkel größer sein muss, als der erste Aperturwinkel. Der zweite Aperturwinkel könnte zwar prinzipiell größer als 90° sein, jedoch führt dies aufgrund des großen Winkelspektrums umso mehr zu einem starken Verlust in der Reflektivität am Vielfachschichtsystem des zweiten normal-incidence Kollektorspiegels sowie zu starken Polarisationseffekten. Ferner würde ein solchermaßen ausgebildeter zweiter normal-incidence Kollektorspiegel zu problematischen geometrischen Verhältnissen führen.

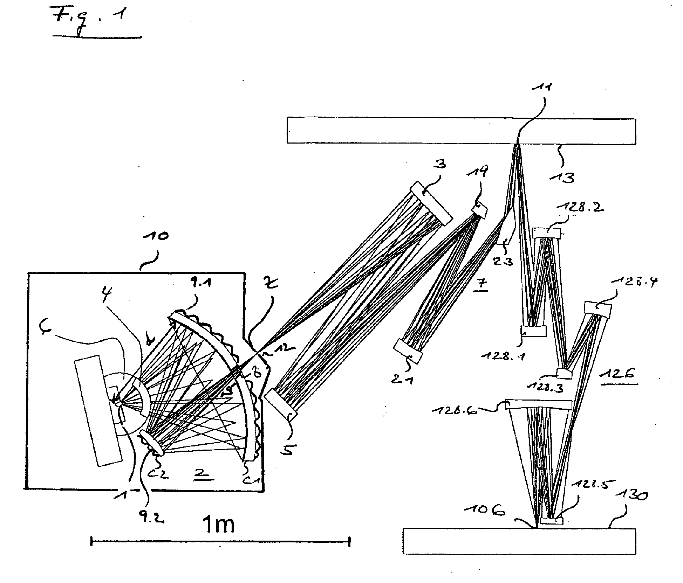

Des Weiteren gezeigt in Figur 2 sind im Lichtweg ausgehend von einer Lichtquelle 1 zu einer ausgeleuchteten Ebene, die als Feldebene 13 bezeichnet wird, optische Komponenten eines Beleuchtungssystems sowie das Projektionsobjektiv 126 einer Projektionsbelichtungsanlage. Alle Komponenten des Beleuchtungssystems und des Projektionsobjektives tragen dieselben Bezugsziffern wie die entsprechenden Komponenten in Figur 1. Betreffend diese Komponenten wird auf die Beschreibung zu Figur 1 verwiesen.

In Figur 1 ist eine Projektionsbelichtungsanlage gezeigt, deren Beleuchtungssystem ein erfindungsgemäßes Kollektorsystem 2 umfasst. Das Kollektorsystem ist erfindungsgemäß als Schiefspiegelsystem in einer Schwarzschildanordung ausgebildet, d.h. erster und zweiter normal-incidence Kollektorspiegel, C1 und C2, sind nicht axialsymmetrisch angeordnet bzw. ausgeformt. In schematisch vereinfachter Darstellung wird ein konkav ausgeformter erster normal-incidence Kollektorspiegel C1 gezeigt, der das Licht auf den zweiten normal-incidence Kollektorspiegel C2 zurückfaltet. Hierbei wird unter einem normal-incidence Spiegel in der vorliegenden Anmeldung ein solcher Spiegel verstanden, bei dem die Einfallswinkel zur Spiegelnormalen kleiner als 70° sind. Mit dieser Bedingung wird auch der Begriff des Zurückfaltens des Strahlengangs durch den ersten, konkav ausgeformten normal-incidence Kollektorspiegel C1 festgelegt.

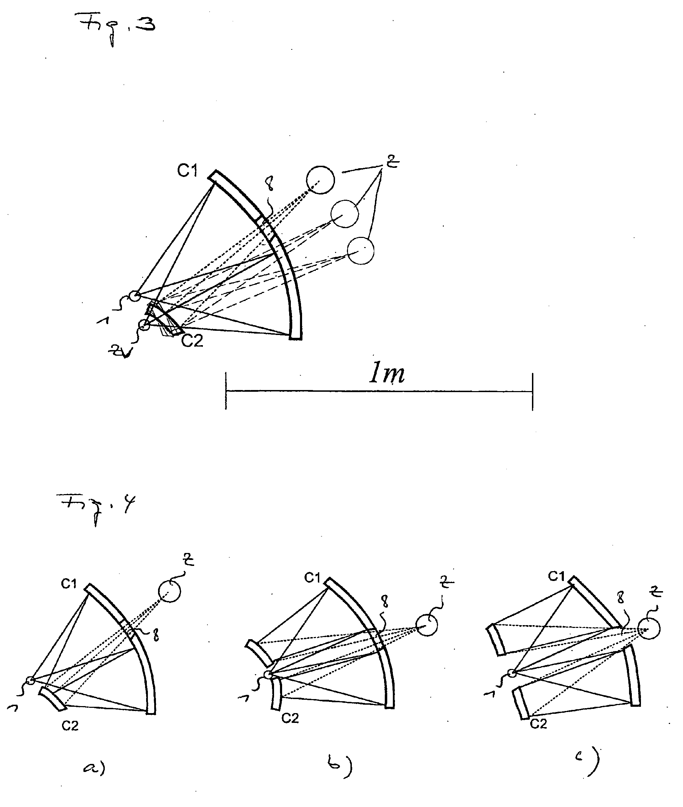

Erfindungsgemäß hat der erste normal-incidence Kollektorspiegel C1 keine verkleinernde Abbildungswirkung auf das Bild der Lichtquelle, so dass der vom ersten Kollektorspiegel C1 aufgenommene erste Aperturwinkel größer oder im Wesentlichen gleich dem zweiten Aperturwinkel ist, welcher vom ersten Kollektorspiegel C1 abgegeben und vom zweiten Kollektorspiegel C2 aufgenommen wird. Durch die Wirkung des erfindungsgemäßen ersten normal-incidence Kollektorspiegels C1 wird die Lichtquelle 1, wie in Figur 3 gezeigt, in ein virtuelles Zwischenbild Zᵥ abgebildet, das einen Abstand zum ersten normal-incidence Kollektorspiegel C1 aufweist, welcher gleich oder größer dem Abstand der Lichtquelle 1 zum normal-incidence Kollektorspiegel C1 ist. Durch die schiefspieglige Anordnung, wird vorzugsweise ein gegenüber dem Stand der Technik deutlich größerer normal-incidence Kollektorspiegel C2 außeraxial angeordnet, d.h. er wird seitlich neben der Lichtquelle 1 positioniert.

Ausgehend von der gewählten Positionierung des zweiten normal-incidence Kollektorspiegels C2 wird dieser in seiner Größe vorzugsweise so angepasst, dass er den gesamten zweiten Aperturwinkel der vom ersten normal-incidence Kollektorspiegel C1 ausgehenden Strahlung abdeckt. Ferner wird der zweite normal-incidence Kollektörspiegel C2 vorzugsweise so ausgestaltet, dass das Zwischenbild Z der Lichtquelle 1 im Wesentlichen im Bereich eines Durchgangs 8 durch den ersten normal-incidence Kollektorspiegel C2 ausgebildet wird.

In einer weiteren Ausgestaltung wird das Zwischenbild Z der Lichtquelle 1 auf der dem zweiten normal-incidence Kollektorspiegel C2 gegenüberliegenden Seite des ersten normal-incidence Kollektorspiegels C1 ausgebildet. Die vom zweiten normal-incidence Kollektorspiegel C2 ausgehende Strahlung wird dabei vorteilhafterweise ebenfalls durch einen Durchgang 8 im ersten normal-incidence Kollektorspiegel C1` geführt und außerhalb des Bereichs der Rückwandung, einschließlich eventueller Kühleinrichtungen des ersten normal-incidence Kollektorspiegels C1, auf das Zwischenbild Z abgebildet.

Die Ausbildung des Zwischenbilds Z der Lichtquelle 1 ist von Vorteil, da es so möglich ist, die Lichtquelle 1 und das Kollektorsystem 2 in ein vom nachfolgenden System atmosphärisch getrenntes Kompartiment einzuschließen. Ein solches Kompartiment ist in Figur 1 skizziert und mit dem Bezugszeichen 10 versehen. Außerdem ist es aufgrund der Ausbildung des Zwischenbilds Z der Lichtquelle 1 möglich, eine Blende 12, welche beispielsweise mit einem Gitterspektralfilter für die spektrale Filterung der Beleuchtung zusammenwirkt, in den Strahlengang aufzunehmen.

Wird für den ersten normal-incidence Kollektorspiegel C1 ein Segment mit einer Symmetrieachse verwendet, so liegt weder die Lichtquelle 1 noch der zweite normal-incidence Kollektorspiegel C2 auf dieser Symmetrieachse, sondern sind zu dieser gegenüberliegend und in einem Abstand positioniert. Hierbei wird der Abstand als Mittelpunktsabstand des zweiten normal-incidence Kollektorspiegels C2 und der Lichtquelle 1 definiert. Dieser Abstand ist mindestens so groß, dass sich der gesamte zweite normal-incidence Kollektorspiegel C2 außerhalb des lichtquellennahen Bereichs befindet, wobei unter dem lichtquellennahen Bereich bevorzugt ein Abstandsbereich zum Quellpunkt der EUV-Lichtquelle von wenigstens 100 mm und besonders bevorzugt von 200 mm verstanden wird.

Fehlt eine solche Symmetrieachse am ersten normal-incidence Kollektorspiegel C1, so bezieht sich die beabstandete Positionierung des zweiten normal-incidence Kollektorspiegels C2 auf den Lotabstand zur einer Geraden, die durch die EUV-Lichtquelle 1 und den Scheitelpunkt S des ersten normal-incidence Kollektorspiegels C1 festgelegt wird. Der Scheitelpunkt S bei einem mehrsegmentigen ersten normal-incidence Kollektorspiegel C1 wird als Scheitelpunkt der Einhüllenden der Spiegelfläche definiert.

Auf diese Art und Weise kann die von der Lichtquelle ausgehende Strahlung ohne Abschattungsverluste zum ersten normal-incidence Kollektorspiegel C1 gelangen und zugleich ein hinreichender Abstand zwischen dem ersten und dem zweiten normal-incidence Kollektorspiegel, C1 und C2, erreicht werden, wobei dieser Abstand annähernd so groß ist, wie der Abstand zwischen der Lichtquelle 1 und dem ersten normal-incidence Kollektorspiegel C1.

Durch den schiefspiegligen Aufbau des erfindungsgemäßen Kollektors und die damit mögliche Vergrößerung des zweiten Kollektorspiegels C2 sowie dessen verlängerten Abstand zum ersten Kollektorspiegel C1 gelingt es, die aus dem Stand der Technik bekannte Begrenzung der numerischen Apertur bei Schwarzschild-Kollektoren für EUV-Lichtquellen zu überwinden. Hierbei sind die Einfallswinkel am zweiten Kollektorspiegel C2 auch bei einer numerischen Apertur von NA > 0,6 und größer, welche der erste Kollektorspiegel C1 von der Lichtquelle 1 aufnimmt, noch so hinreichend klein, dass die Reflektionsverluste und die unerwünschten Polarisationseffekte tolerierbar sind. Bevorzugt werden daher möglichst große erste Aperturwinkel, d. h. für die numerische Apertur, mit der erste normal-incidence Kollektorspiegels C1 Strahlung von der Lichtquelle 1 sammelt, wird ein Wert von NA ≥0,5 und besonders von NA ≥0,6 und insbesondere von NA ≥0,7 bevorzugt. Aufgrund des erfindungsgemäß schiefspiegligen Aufbaus des Kollektors sind auch besonders hohe erste Aperturwinkel und somit numerischen Aperturen von NA ≥0,85 denkbar.

Figur 1 skizziert eine vorteilhafte Ausgestaltung des erfindungsgemäßen Kollektors, beim dem sich der von der Lichtquelle 1 ausgehende erste Strahlengang und jener, welcher zum zweiten normal-incidence Kollektorspiegel C2 verläuft und als zweiter Strahlengang bezeichnet wird, ab einer gewissen Entfernung zur Lichtquelle 1 nicht mehr durchdringen. Bevorzugt wird ein vom zweiten Strahlengang nicht durchdrungener Bereich, mit einem Mindestradius von 100 mm und besonders bevorzugt von 200 mm um die Lichtquelle 1. Im Allgemeinen wird bevorzugt, dass bei einem gegebenen minimalen Abstand d von der Lichtquelle 1 zur Spiegelfläche des ersten normal-incidence Kollektorspiegels C1 ein Bereich um die Lichtquelle 1 mit einem Mindestradius von d/5 bzw. besonders bevorzugt von d/3 nicht vom zweiten Strahlengang durchschritten wird. Außerdem wird bevorzugt, dass sich in diesem Bereich innerhalb des Mindestradius keine optischen Komponenten einschließlich der zugeordneten mechanischen Haltestrukturen befinden. Hierdurch wird als zusätzlicher erfindungsgemäßer Vorteil erreicht, dass hinreichender Bauraum zur Ausgestaltung eines die Lichtquelle 1 umschließenden Kompartiments 6 zur Verfügung steht. In einem solchen Kompartiment 6 wird die Atmosphäre, welche die Lichtquelle 1 umgibt, vom nachfolgenden Bereich des unter Vakuum stehenden Beleuchtungssystems getrennt, so dass keine von der Lichtquelle 1 ausgehende Verschmutzung in diesen Bereich gelangen kann. Hierbei wird beispielsweise ein Partikelfilter verwendet, der in einer möglichen Ausgestaltung als Folie aus Zirkon aufgebaut ist, um die EUV-Strahlung passieren zu lassen, jedoch die von der Lichtquelle 1 ausgehende Debris zurückhält. Ferner können zusätzlich oder alternativ elektrische oder magnetische Felder zum Abfangen von elektrisch geladenen Schutzpartikeln eingesetzt werden. Auch großbauende EUV-Lichtquellen, wie z.B. Entladungsquellen, behindern bei einem erfindungsgemäß schiefspiegligen Schwarzschild-Kollektorsystem mit einer seitlichen Positionierung des zweiten normal-incidence Kollektorspiegels C2 nicht das Zurückfalten des Strahlengangs in die Nähe der Lichtquelle 1.

In einer ersten bevorzugten Ausführungsform ist die reflektive Fläche des ersten normal-incidence Kollektorspiegels C2 als-Segment eines Ellipsoids ausgeformt, während der außeraxial positionierte zweite normal-incidence Kollektorspiegel C2 als Segment eines Hyperboloids ausgebildet ist. Insbesondere der erste normal-incidence Kollektorspiegel C1 wird zum Erreichen einer hinreichend großen Apertur eine große Baugröße aufweisen, so dass er in einer vorteilhaften Ausgestaltung der Erfindung aus mehreren Einzelsegmenten aufgebaut ist. Diese können direkt anschließend einander auf einer gemeinsamen Trägerstruktur gehaltert werden oder individuelle und gegeneinander bewegliche Halterungen aufweisen. Auch der zweite normal-incidence Kollektorspiegel C2 kann solchermaßen aus Einzelsegmenten aufgebaut sein. Aufgrund der hohen thermischen Belastung der normal-incidence Kollektorspiegel C1 und C2 werden diese vorteilhafterweise gekühlt. Hierzu können als Kühleinrichtungen 8.1 und 8.2 für den ersten Kollektorspiegel C1 oder den zweiten Kollektorspiegel C2 beispielsweise solche eingesetzt werden, die mit einer Mediumkühlung, z. B. mit Wasser, oder einer Peltierkühlung arbeiten. Durch die erfindungsgemäße Rückfaltung im Kollektorsystem mittels einer schiefspiegligen Anordnung ist sowohl am ersten wie auch am zweiten normal-incidence Kollektorspiegel C1 und C2 genügend rückwärtiger Bauraum vorhanden, um eine solche Kühleinrichtung unterbringen zu können.

Des Weiteren sind in Figur 1 die dem erfindungsgemäßen Kollektorsystem 2 im Lichtweg von der Lichtquelle 1 zur ausgeleuchteten Feldebene 13 nachgeordneten optischen Komponenten des Beleuchtungssystems sowie das Projektionsobjektiv 126 gezeigt. Im Einzelnen ist in Figur 1 Folgendes dargestellt: Ein Retikel bzw. eine Maske 11 wird in der Feldebene 13 eines Projektionsbelichtungssystems positioniert und mittels einer Reduktionsoptik 126 auf dessen Bildebene 130 abgebildet, in der sich typischerweise ein mit einem lichtempfindlichen Material versehener Wafer 106 befindet. Figur 1 zeigt hierzu beispielhaft ein Projektionsobjektiv bestehend aus sechs Einzelspiegeln 128.1 bis 128.6, das beispielsweise aus der US 6 600 552, die vollumfänglich in die vorliegende Anmeldung mit aufgenommen wird, hervorgeht. Skizziert ist ferner eine im Idealfall telezentrische Beleuchtung der Bildebene 130, d. h. der Hauptstrahl eines Strahlbüschels, welcher-von einem Feldpunkt der Feldebene 13 ausgeht, schneidet die Bildebene 130 senkrecht. Ferner weist das Projektionsobjektiv 126 eine Eintrittspupille auf, die im Allgemeinen mit der Austrittspupille des Beleuchtungssystems zusammenfällt.

Figur 1 zeigt außerdem den typischen Aufbau eines EUV-Beleuchtungssystems, welches als doppelfacettiertes Beleuchtungssystem gemäß der US 6 198 793 B1 ausgebildet wird, wobei der Inhalt dieses Dokuments vollumfänglich in die vorliegende Anmeldung mit aufgenommen wird. Ein solches System umfasst ein erstes optisches Element mit ersten Rasterelementen 3, welches auch als Feldfacettenspiegel 3 bezeichnet wird. Im Strahlengang anschließend folgt ein zweites optisches Element mit zweiten Rasterelementen 5, das üblicherweise Pupillenfacettenspiegel 5 genannt wird.

Feld- und Pupillenfacettenspiegel 3, 5 dienen zur Ausleuchtung eines Felds in der Feldebene 13 sowie der Gestaltung der Ausleuchtung in der Austrittspupille des Beleuchtungssystems. Die Wirkung jeder Feldwabe ist dergestalt, dass sie ein Bild der Lichtquelle 1 ausbildet, wobei durch die Vielzahl Feldfacetten eine Vielzahl von so genannten sekundären Lichtquellen gebildet wird. Die sekundären Lichtquellen werden in oder nahe der Ebene, in welcher der Pupillenfacettenspiegel 5 angeordnet ist, ausgebildet. Damit, wie in Figur 1 dargestellt, die sekundären Lichtquellen im Bereich des Pupillenfacettenspiegels 5 zu liegen kommen, können die Feldfacetten selbst eine optische Wirkung, beispielsweise eine sammelnde optische Wirkung, aufweisen. Von den nachfolgenden optischen Elementen werden diese sekundären Lichtquellen als tertiäre Lichtquellen in die Austrittspupille des Beleuchtungssystems abgebildet.

Ferner wird jede Feldwabe durch die Facetten des Pupillenfacettenspiegels 5 und den nachfolgenden optischen Elementen der zweiten optischen Komponente 7, die im Beispiel aus Figur 1 aus den drei optischen Elementen erstes reflektives optisches Element 19, zweites reflektives optisches Element 21 und den grazing-incidence-Spiegel 23 bestehen, in die Feldebene 13 abgebildet. Die sich dort überlagernden Bilder der Feldfacetten dienen zur Ausleuchtung einer Maske 11 in der Feldebene 13, wobei typischerweise, ausgehend von rechteckförmigen oder bogenförmigen Feldfacetten, eine Ausleuchtung in der Feldebene 13 in der Form eines Ringfeldsegments entsteht. Im Allgemeinen ist das Mikrolithographiesystem als scannendes System ausgebildet, so dass die Maske 11 in der Feldebene 13 und ein Wafer 106 in der Bildebene 130 synchron bewegt werden, um eine Ausleuchtung bzw. eine Belichtung zu bewirken.

In Figur 3 ist eine erfindungsgemäße Ausgestaltung des schiefspiegligen Schwarzschild-Kollektors dargestellt, bei der für den zweiten normal-incidence Kollektorspiegel C2 unterschiedliche Kippwinkel eingestellt werden können. Ausgehend von den festgelegten Positionen der Lichtquelle 1 und des ersten normal-incidence Kollektorspiegel C1 ist die Lage des virtuellen Zwischenbilds Zᵥ festgelegt. Durch die Einstellungsvariation des zweiten normal-incidence Kollektorspiegels C2 kann die Lage und die Orientierung des vergrößerten Zwischenbilds Z der Lichtquelle 1 eingestellt werden. Beispielhaft sind in Figur 3 drei verschiedene Kippwinkel des zweiten normal-incidence Kollektorspiegels C2 skizziert. Auf diese Weise ist es möglich, den sich für die nachfolgenden Teile des Mikrolithographiesystems ergebenden Bauraumanforderungen nachzukommen oder bei der Verwendung einer EUV-Lichtquelle mit einer Vielzahl von Quellpunkten zwischen den einzelnen Quellpunkten zu wechseln. Ist der zweite normal-incidence Kollektorspiegel C2 aus Einzelsegmenten aufgebaut, so es insbesondere bei der Überlagerung einer Vielzahl von Quellpunkten vorteilhaft, wenn für die Einzelsegmente die zugeordneten Kippwinkel individuell einstellbar sind. Im Allgemeinen ist für einen zweiten normal-incidence Kollektorspiegel C2 mit einstellbarem Kippwinkel entweder die Durchtrittsöffnung 8 im ersten normal-incidence Kollektorspiegel C1 hinreichend groß zu gestalten oder es ist eine Anpassung der Durchtrittsöffnung 8 für die jeweilige Einstellung des zweiten normal-incidence Kollektorspiegels C2 vorzunehmen. Wird der erste normal-incidence Kollektorspiegel C1 aus Einzelsegrrrenten mit individuellen Trägerelementen modular aufgebaut, so kann das Versetzen der Durchrittsöffnung 8 relativ einfach realisiert werden.

In den Figuren 4 a - c sind vorteilhafte Ausgestaltungen des schiefspiegligen Schwarzschild-Kollektors dargestellt. Die Figur 4a zeigt den oben beschriebenen schiefspiegligen Aufbau des zweispiegligen Kollektors mit dem zweiten normal-incidence-Kollektorspiegel C2 im Wesentlichen neben der Quelle angeordnet. In Figur 4b ist der zweite normal-incidence-Kollektorspiegel C2 so angeordnet, dass die von der Quelle abgestrahlte Leistung eine zentrale Öffnung des zweite normal-incidence-Kollektorspiegel C2 passiert. In dieser Ausgestaltung, die beispielsweise auch einen rotationssymmetrischen Kollektorsystem aufweisen kann, ist allerdings aufgrund der kleinen Öffnung im zweiten normal-incidence-Kollektorspiegel C2 die aufnehmbare Kollektionsapertur begrenzt. In Figur 4c weisen der erste und der zweite normal-incidence Kollektorspiegel C1 und C2 jeweils Ausformungen auf, die der Spiegelform einen konischen Anteil hinzufügen. Die Erfinder haben erkannt, dass bei einer solchen Ausgestaltung der Spiegel als nicht-abbildende optische Elemente mit konischen Anteilen der erfindungsgemäße Aufbau des Schwarzschild-Kollektors mit großer Kollektionsapertur besonders gut realisierbar ist. Hierbei sind konische Konstanten dem Fachmann beispielsweise aus Standardsoftwarepaketen für optisches Design bekannt.

Durch die Hinzunahme konischer Anteile auf dem ersten normal-incidence Kollektorspiegel C2 kann, wie in Figur 4c dargestellt, ein zentriertes System realisiert werden, bei dem die Lichtquelle 1 im Wesentlichen zentral im zweiten normal-incidence Kollektorspiegels C2 positioniert wird. Mit dieser erfindungsgemäßen Maßnahme kann wegen der konischen Anteile auf dem ersten Kollektorspiegel C1 die zentrale Öffnung im zweiten Kollektorspiegel C2 größer gewählt werden, wodurch ein erfindungsgemäßer größerer Aperturwinkel erreicht wird. Der konische Anteil auf dem ersten normal-incidence Kollektorspiegels C1 kann nicht nur dafür genutzt werden, um die Zentralabschattung im zweiten normal-incidence Kollektorspiegels C2 zu vergrößern, sondern auch um wiederum Bauraum für die Lichtquelle 1 und die sie umgebenden Komponenten, wie etwa Partikelfilter, zu schaffen. Dieser Effekt ist in Figur 4c dargestellt.

In einer weiteren vorteilhaften Ausgestaltung der Erfindung wird auf einem der beiden normal-incidence Kollektorspiegel C1 oder C2 die reflektive Oberfläche mit einem Gitter zur spektralen Filterung ausgebildet. Ein solches Gitterspektralfilter ist aus der US 2003/0043455 A1 bekannt, wobei der Inhalt dieser Schrift vollumfänglich in die vorliegende Anmeldung mitaufgenommen wird. Sieht man dieses Spektralgitter am zweiten normal-incidence Kollektorspiegel C2 vor, so kann durch die kombinierte Filterwirkung aus dem Vielfachschichtsystem, welches die Nutzwellenlänge von 13,5 nm und Wellenlängen oberhalb von 100 nm aus der Ausstrahlung der Lichtquelle entnimmt, und dem Gitterspektralfilter, welches so eingestellt wird, dass gerade der Wellenlängenbereich von 7 bis etwa 27 nm selektiert wird, eine spektral besonders reine Ausleuchtung erreicht werden. Aus Platzgründen ist es vorteilhaft, das Blendensystem zur Filterung der unerwünschten Beugungsordnungen im Wesentlichen im Bereich des Durchgangs 8 durch den ersten normal-incidence Kollektorspiegel C1 auszubilden.

In einer Weitergestaltung der Erfindung ist es denkbar, weitere Spiegel in das erfindungsgemäße Kollektorsystem aufzunehmen. Diese können dazu beitragen, ein Bild der Lichtquelle zu erzeugen oder dienen zur weiteren Bauraumanpassung des Kollektors. Außerdem ist es denkbar, einen der Spiegel, der dem ersten normal-incidence Kollektorspiegel C1 nachfolgt, als grazing-incidence Spiegel auszubilden. Dies kann unter Umständen auch der dem ersten normal-incidence Kollektorspiegel C1 direkt nachfolgende zweite Kollektorspiegel sein.

In einer vorteilhaften Ausführungsform kann mindestens einer der Kollektorspiegel der Erfindung gemäß der EP 1 189 089, welche vollumfänglich in die vorliegende Anmeldung mit aufgenommen wird, mechanisch dergestalt gehaltert sein, dass sich bei Temperaturänderungen die optischen Eigenschaften nicht ändern. Ferner kann mindestens einer der Spiegel über Manipulatoren regelbar verfahrbar bzw. kippbar ausgelegt sein, um während der Montage und während des Betriebes die Kollektorspiegel aktiv zu justieren bzw. in einem idealen Justagezustand zu halten.

Durch die Angabe der erfindungsgemäß schiefspiegligen Anordnung der normal-incidence Spiegel des Schwarzschild-Kollektors wird zugleich eine Projektionsbelichtungsanlage offenbart, welche ein EUV-Beleuchtungssystem mit einem solchen Kollektorsystem umfasst. Ferner wird ein Verfahren zum Belichten zur Herstellung mikroelektronischer Bauteile angegeben, bei dem eine solchermaßen charakterisierte Projektionsbelichtungsanlage verwendet wird.

### Bezugszeichenliste

- 1: Lichtquelle
- 2, 2': Kollektorsystem
- 3: erstes optisches Element mit ersten Rasterelementen (Feldfacettenspiegel)
- 4: Partikelfilter
- 5: zweites optisches Element mit zweiten Rasterelementen(Pupillenfacettenspiegel)
- 6: Kompartiment der Lichtquelle
- 7: zweite optische Komponente
- 8: Durchgang im ersten normal-incidence Spiegel
- 9.1,9.2: Vorrichtung zum Kühlen
- 10: Kompartiment zum Einschluss der Lichtquellen 1 und des Kollektorsystems 2
- 11: strukturtragende Maske
- 13: Feldebene
- 19: erstes reflektives optisches Element
- 21: zweites reflektives optisches Element
- 23: grazing-incidence Spiegel
- 27: Austrittspupille des Beleuchtungssystems
- 104: Maske
- 106: mit einem lichtempfindlichen Material versehener Wafer
- 126: Projektionsobjektiv
- 128.1, 128.2,: Spiegel des Projektionsobjektives
- 128.3,128.4,:
- 128.5, 128.6:
- 130: Bildebene
- d: minimaler Abstand der Lichtquelle 1 zur Spiegelfläche des ersten normal-incidence Kollektorspiegels C1
- C1, C1': erster normal-incidence Kollektorspiegel
- C2, C2': zweiter normal-incidence Kollektorspiegel
- Z: Zwischenbild der Lichtquelle
- Zᵥ: virtuelles Zwischenbild der Lichtquelle
- S: Scheitelpunkt des erster normal-incidence Kollektorspiegels

## Patentansprüche

1. Kollektorsystem (2) für eine Lichtquelle (1), insbesondere eine EUV-Lichtquelle,
1.1 mit einem ersten Kollektorspiegel (C1) und einem zweiten Kollektorspiegel (C2); wobei
1.2 der erste Kollektorspiegel (C1) derart angeordnet ist, dass er den von der Lichtquelle (1) ausgehenden ersten Strahlengang in einen zum zweiten Kollektorspiegel (C2) gehenden zweiten Strahlengang reflektiert;
1.3 der erste Kollektorspiegel (C1) ein konkaver normal-incidence Spiegel ist;
1.4 der erste Kollektorspiegel (C1) derart angeordnet ist, dass er Strahlung von der Lichtquelle (1) mit einer numerischen Apertur von NA≥ 0,5 und bevorzugt von NA ≥ 0,6 und besonders bevorzugt von NA ≥ 0,7 aufnimmt;
1.5. der zweite Kollektorspiegel (C2) mit einem Lotabstand zur Geraden, die durch die Lichtquelle (1) und den Scheitelpunkt (s) des ersten Kollektorspiegels (C1) festgelegt ist, positioniert ist und
1.6. der erste Kollektorspiegel (C1) eine Öffnung (8) aufweist, durch die das vom zweiten Kollektorspiegel (C2) reflektierte Strahlbüschel hindurchtritt.

2. Kollektorsystem (2) für eine Lichtquelle (1), insbesondere eine EUV-Lichtquelle, nach Anspruch 1, **dadurch gekennzeichnet, dass** der erste Kollektorspiegel (C1) den Strahlengang in Richtung der Lichtquelle (1) zurückfaltet.

3. Kollektorsystem (2) für eine Lichtquelle (1), insbesondere eine EUV-Lichtquelle, nach einem der Ansprüche 1 bis 2, **dadurch gekennzeichnet, dass** der erste Kollektorspiegel (C1) und/oder der zweite Kollektorspiegel (C2) konische Anteile für die Ausformung der Reflektionsfläche enthalten.

4. Kollektorsystem (2) für eine Lichtquelle (1), insbesondere eine EUV-Lichtquelle, nach einem der Ansprüche 1 bis 3, **dadurch gekennzeichnet, dass** wenigstens ein Kollektorspiegel eine Vorrichtung (8.1, 8.2) zum Kühlen umfasst.

5. Kollektorsystem (2) für eine Lichtquelle (1), insbesondere eine EUV-Lichtquelle, nach einem der Ansprüche 1 bis 4, **dadurch gekennzeichnet, dass** das Kollektorsystem (2) ein Gitterspektralfilter umfasst.

6. Kollektorsystem (2) für eine Lichtquelle (1), insbesondere eine EUV-Lichtquelle, nach Anspruch 5, **dadurch gekennzeichnet, dass** das Gitterspektralfilter auf der Spiegelfläche des ersten Kollektorspiegels (C1) und/oder des zweiten Kollektorspiegels (C2) ausgebildet ist.

7. Kollektorsystem (2) für eine Lichtquelle (1), insbesondere eine EUV-Lichtquelle, nach einem der Ansprüche 1 bis 6, **dadurch gekennzeichnet, dass** der lichtquellennahe Bereich mit einem Abstand von 100 mm und bevorzugt von 200 mm zur EUV-Lichtquelle (1) ausschließlich vom ersten Strahlengang durchlaufen wird.

8. Kollektorsystem (2) für eine Lichtquelle (1), insbesondere eine EUV-Lichtquelle, nach einem der Ansprüche 1 bis 6, **dadurch gekennzeichnet, dass** bei einem gegebenen minimalen Abstand d von der Lichtquelle (1) zur Spiegelfläche des ersten normal-incidence Kollektorspiegels (C1) ein Bereich um die Lichtquelle (1) mit einem Mindestradius von d/5 und besonders bevorzugt von d/3 ausschließlich vom ersten Strahlengang durchlaufen wird und sich innerhalb dieses Mindestradius um die Lichtquelle (1) keine optischen Komponenten, einschließlich der zugeordneten mechanischen Haltestrukturen, befinden.

9. Kollektorsystem (2) für eine Lichtquelle (1), insbesondere eine EUV-Lichtquelle, nach Anspruch 7 oder 8, **dadurch gekennzeichnet, dass** die EUV-Lichtquelle (1) im lichtquellennahen Bereich oder im Bereich innerhalb des Mindestradius um die Lichtquelle (1) in einem Kompartiment (6) eingeschlossen ist, dessen Atmosphäre vom restlichen Teil des Beleuchtungssystems getrennt ist.

10. Kollektorsystem (2) für eine Lichtquelle (1), insbesondere eine EUV-Lichtquelle, nach einem der Ansprüche 7 bis 9, **dadurch gekennzeichnet, dass** im lichtquellennahen Bereich oder im Bereich innerhalb des Mindestradius um die Lichtquelle (1) ein Partikelfilter (4) und/oder eine Teilchenfalle und/oder Mittel zum Abbremsen schneller und/oder geladener Teilchen vorgesehen sind.

11. Kollektorsystem (2) für eine Lichtquelle (1), insbesondere eine EUV-Lichtquelle, nach einem der Ansprüche 1 bis 10, **dadurch gekennzeichnet, dass** das Kollektorsystem (2) ein reelles Zwischenbild der Lichtquelle (1) erzeugt.

12. Kollektorsystem (2) für eine Lichtquelle (1), insbesondere eine EUV-Lichtquelle, nach Anspruch 11, **dadurch gekennzeichnet, dass** das reelle Zwischenbild der Lichtquelle (1) ein vergrößertes Zwischenbild ist.

13. Kollektorsystem (2) für eine Lichtquelle, insbesondere eine EUV-Lichtquelle nach einem der Ansprüche 1 bis 12, **dadurch gekennzeichnet, dass** das reelle Zwischenbild (Z) der Lichtquelle im Wesentlichen im Bereich der Öffnung ausgebildet wird.

14. Kollektorsystem (2) für eine Lichtquelle (1), insbesondere eine EUV-Lichtquelle, nach einem der Ansprüche 1 bis 13, **dadurch gekennzeichnet, dass** der zweite Kollektorspiegel (C2) ein normal-incidence Spiegel ist.

15. Kollektorsystem (2) für eine Lichtquelle (1), insbesondere eine EUV-Lichtquelle, nach einem der Ansprüche 1 bis 14, **dadurch gekennzeichnet, dass** der zweite Kollektorspiegel (C2) in seiner Position und seiner Orientierung gegenüber dem ersten Kollektorspiegel (C1) variabel einstellbar ist.

16. Beleuchtungssystem umfassend
16.1. eine Lichtquelle (1), insbesondere eine EUV-Lichtquelle;
16.2. eine Feldebene (13);
16.3. im Lichtweg von der Lichtquelle (1) zur Feldebene (13) befindet sich zwischen der Lichtquelle (1) und der Feldebene (13) ein Kollektorsystem (2) nach einem der Ansprüche 1 bis 15.

17. Beleuchtungssystem nach Anspruch 16 umfassend ein erstes optisches Element mit ersten Rasterelementen (3) und ein zweites optisches Element mit zweiten Rasterelementen (5), die im Lichtweg nach dem Kollektorsystem (2) und vor der Feldebene (13) angeordnet sind.

18. Beleuchtungssystem nach Anspruch 16 oder 17 umfassend eine zweite optische Komponente (7) zur Ausleuchtung eines Felds in der Feldebene (13), die im Lichtweg nach dem Kollektorsystem (2) und vor der Feldebene (13) und, falls das Beleuchtungssystem ein zweites optisches Element mit zweiten Rasterelementen (5) umfasst, nach diesem angeordnet ist.

19. Projektionsbelichtungsanlage, **dadurch gekennzeichnet, dass** die Projektionsbelichtungsanlage ein Kollektorsystem (2) gemäß einem der Ansprüche 1 bis 15 umfasst.

20. Verfahren zur Herstellung mikroelektronischer Bauteile, **dadurch gekennzeichnet, dass** eine Projektionsbelichtungsanlage, die ein Kollektorsystem (2) gemäß einem der Ansprüche 1 bis 15 umfasst, verwendet wird.

## Claims

1. A collector system (2) for a light source (1), especially an EUV light source;
1.1 comprising a first collector mirror (C1) and a second collector mirror (C2), with
1.2 the first collector mirror (C1) being arranged in such a way that the first beam path originating from the light source (C1) reflects into a second beam path going to the second collector mirror (C2);
1.3 the first collector mirror (C1) being a concave normal-incidence mirror;
1.4 the first collector mirror (C1) being arranged in such a way that it receives radiation from the light source (C1) with a numerical aperture of NA ≥ 0.5, and preferably NA ≥ 0.6, and especially preferably NA ≥ 0.7;
1.5 the second collector mirror (C2) being positioned with a perpendicular distance to the straight line which is determined by the light source (1) and the vertex (s) of the first collector mirror (C1), and
1.6 the first collector mirror (C1) has an opening (8) through which the ray pencil passes which is reflected by the second collector mirror (C2).

2. A collector system (2) for a light source (1), especially an EUV light source, according to claim 1, **characterized in that** the first collector mirror (C1) folds back the beam path in the direction of the light source (1).

3. A collector system (2) for a light source (1), especially an EUV light source, according to one of the claims 1 to 2, **characterized in that** the first collector mirror (C1) and/or the second collector mirror (C2) comprise conical portions for forming the reflection surface.

4. A collector system (2) for a light source (1), especially an EUV light source, according to one of the claims 1 to 3, **characterized in that** at least one collector mirror comprises an apparatus (8.1, 8.2) for cooling.

5. A collector system (2) for a light source (1), especially an EUV light source, according to one of the claims 1 to 4, **characterized in that** the collector system (2) comprises a grating spectral filter.

6. A collector system (2) for a light source (1), especially an EUV light source, according to claim 5, **characterized in that** the grating spectral filter is formed on the mirror surface of the first collector mirror (C1) and/or the second collector mirror (C2)

7. A collector system (2) for a light source (1), especially an EUV light source, according to one of the claims 1 to 6, **characterized in that** the region close to the light source is passed exclusively by the first beam path at a distance of 100 mm and preferably 200 mm from the EUV light source (1).

8. A collector system (2) for a light source (1), especially an EUV light source, according to one of the claims 1 to 6, **characterized in that** a region about the light source (1) with a minimum radius of d/5 and especially preferably of d/3 is passed through exclusively by the first beam path at a given minimum distance d from the light source (1) to the mirror surface of the first normal-incidence collector mirror (C1) and within said minimum radius about the light source (1) there are no optical components, including the associated mechanical holding structures.

9. A collector system (2) for a light source (1), especially an EUV light source, according to claim 7 or 8, **characterized in that** the EUV light source (1) is enclosed in a compartment (6) in the region close to the light source (1) or in a region within the minimum radius about the light source (1), the atmosphere of said compartment being separated from the remaining part of the illumination system.

10. A collector system (2) for a light source (1), especially an EUV light source, according to one of the claims 7 to 9, **characterized in that** a particle filter (4) and/or a particle trap and/or means for braking fast and/or charged particles are provided in the region close to the light source or in the region within the minimum radius about the light source (1).

11. A collector system (2) for a light source (1), especially an EUV light source, according to one of the claims 1 to 10, **characterized in that** the collector system (2) produces a real intermediate image of the light source (1).

12. A collector system (2) for a light source (1), especially an EUV light source, according to claim 11, **characterized in that** the real intermediate image of the light source (1) is an enlarged intermediate image.

13. A collector system (2) for a light source (1), especially an EUV light source, according to one of the claims 1 to 12, **characterized in that** the real intermediate image (Z) of the light source is formed substantially in the region of the opening.

14. A collector system (2) for a light source (1), especially an EUV light source, according to one of the claims 1 to 13, **characterized in that** the second collector mirror (C2) is normal-incidence mirror.

15. A collector system (2) for a light source (1), especially an EUV light source, according to one of the claims 1 to 14, **characterized in that** in relation to the first collector mirror (C1) the second collector mirror (C2) is variably adjustable in respect of its position and its orientation.

16. An illumination system, comprising
16.1 a light source (1), especially an EUV light source;
16.2 a field plane (13);
16.3 in the light path from the light source (1) to the field plane (13) a collector system (2) according to one of the claims 1 to 15 is disposed between the light source (1) and the field plane (13).

17. An illumination system according to claim 16, comprising a first optical element with first raster elements (3) and a second optical element with second raster elements (5) which are arranged in the light path after the collector system (2) and before the field plane (13).

18. An illumination system according to claim 16 or 17, comprising a second optical component (7) for illuminating a field in the field plane (13) which is arranged in the light path after the collector system (2) and before the field plane (13) and, if the illumination system comprises a second optical element with second raster elements (5), is arranged behind the same.

19. A projection exposure system, **characterized in that** the projection exposure system comprises a collector system (2) according to one of the claims 1 to 15.

20. A method for producing microelectronic components, **characterized in that** a projection exposure system is used which comprises a collector system (2) according to one of the claims 1 to 15.

## Revendications

1. Système de collecteur (2) pour une source lumineuse (1), en particulier une source lumineuse à EUV,
1.1 avec un premier miroir collecteur (C1) et un deuxième miroir collecteur (C2) ; dans lequel
1.2 le premier miroir collecteur (C1) est disposé de telle façon qu'il réfléchit le premier faisceau provenant de la source lumineuse (1) dans un deuxième faisceau allant vers le deuxième miroir collecteur (C2) ;
1.3 le premier miroir collecteur (C1) est un miroir concave à incidence normale ;
1.4 le premier miroir collecteur (C1) est disposé de telle façon qu'il capte le rayonnement de la source lumineuse (1) avec une ouverture numérique de NA ≥ 0,5 et de préférence de NA ≥ 0,6 et en particulier de NA ≥ 0,7 ;
1.5 le deuxième miroir collecteur (C2) est positionné à une distance verticale de la droite passant par la source lumineuse (1) et le sommet (s) du premier miroir collecteur (C1), et
1.6 le premier miroir collecteur (C1) possède une ouverture (8) à travers laquelle passe le faisceau réfléchi par le deuxième miroir collecteur (C2).

2. Système de collecteur (2) pour une source lumineuse (1), en particulier une source lumineuse à EUV, selon la revendication 1, **caractérisé en ce que** le premier miroir collecteur (C1) replie le faisceau en direction de la source lumineuse (1).

3. Système de collecteur (2) pour une source lumineuse (1), en particulier une source lumineuse à EUV, selon l'une des revendications 1 à 2, **caractérisé en ce que** le premier miroir collecteur (C1) et/ou le deuxième miroir collecteur (C2) contiennent des parties coniques destinées à déformer la surface réfléchissante.

4. Système de collecteur (2) pour une source lumineuse (1), en particulier une source lumineuse à EUV, selon l'une des revendications 1 à 3, **caractérisé en ce qu'**au moins un miroir collecteur comprend un dispositif de refroidissement (8.1, 8.2).

5. Système de collecteur (2) pour une source lumineuse (1), en particulier une source lumineuse à EUV, selon l'une des revendications 1 à 4, **caractérisé en ce que** le système de collecteur (2) comprend un filtre spectral à réseau.

6. Système de collecteur (2) pour une source lumineuse (1), en particulier une source lumineuse à EUV, selon la revendication 5, **caractérisé en ce que** le filtre spectral à réseau est formé sur la surface réfléchissante du premier miroir collecteur (C1) et/ou du deuxième miroir collecteur (C2).

7. Système de collecteur (2) pour une source lumineuse (1), en particulier une source lumineuse à EUV, selon l'une des revendications 1 à 6, **caractérisé en ce que** la zone proche de la source lumineuse à une distance de 100 mm et de préférence de 200 mm par rapport à la source lumineuse à EUV (1) est traversée exclusivement par le premier faisceau.

8. Système de collecteur (2) pour une source lumineuse (1), en particulier une source lumineuse à EUV, selon l'une des revendications 1 à 6, **caractérisé en ce qu'**à un distance minimale d donnée de la source lumineuse (1) à la surface réfléchissante du premier miroir collecteur à incidence normale (C1), une zone entourant la source lumineuse (1) sur un rayon minimum de d/5 et de préférence de d/3 est traversée exclusivement par le premier faisceau et il n'y a pas de composants optiques, y compris les structures de fixation mécaniques correspondantes, dans ce rayon minimum autour de la source lumineuse (1).

9. Système de collecteur (2) pour une source lumineuse (1), en particulier une source lumineuse à EUV, selon la revendication 7 ou 8, **caractérisé en ce que** la source lumineuse à EUV (1) est incluse dans la zone proche de la source lumineuse ou dans la zone située dans le rayon minimum autour de la source lumineuse (1) dans un compartiment (6) dont l'atmosphère est séparée du reste du système d'éclairage.

10. Système de collecteur (2) pour une source lumineuse (1), en particulier une source lumineuse à EUV, selon l'une des revendications 7 à 9, **caractérisé en ce qu'**il est prévu dans la zone proche de la source lumineuse ou dans la zone située dans le rayon minimum autour de la source lumineuse (1) un filtre à particules (4) et/ou un piège à particules et/ou des moyens pour freiner les particules rapides et/ou chargées.

11. Système de collecteur (2) pour une source lumineuse (1), en particulier une source lumineuse à EUV, selon l'une des revendications 1 à 10, **caractérisé en ce que** le système de collecteur (2) crée une image intermédiaire réelle de la source lumineuse (1).

12. Système de collecteur (2) pour une source lumineuse (1), en particulier une source lumineuse à EUV, selon la revendication 11, **caractérisé en ce que** l'image intermédiaire réelle de la source lumineuse (1) est une image intermédiaire agrandie.

13. Système de collecteur (2) pour une source lumineuse, en particulier une source lumineuse à EUV, selon l'une des revendications 1 à 12, **caractérisé en ce que** l'image intermédiaire réelle (Z) de la source lumineuse est formée pour l'essentiel au niveau de l'ouverture.

14. Système de collecteur (2) pour une source lumineuse (1), en particulier une source lumineuse à EUV, selon l'une des revendications 1 à 13, **caractérisé en ce que** le deuxième miroir collecteur (C2) est un miroir à incidence normale.

15. Système de collecteur (2) pour une source lumineuse (1), en particulier une source lumineuse à EUV, selon l'une des revendications 1 à 14, **caractérisé en ce que** la position du deuxième miroir collecteur (C2) et son orientation par rapport au premier miroir collecteur (C1) peuvent être réglées de manière variable.

16. Système d'éclairage comprenant
16.1 une source lumineuse (1), en particulier une source lumineuse à EUV ;
16.2 un plan de champ (13) ;
16.3 il est prévu dans le trajet de la lumière de la source lumineuse (1) au plan de champ (13), entre la source lumineuse (1) et le plan de champ (13), un système de collecteur (2) selon l'une des revendications 1 à 15.

17. Système d'éclairage selon la revendication 16 comprenant un premier élément optique avec des premiers éléments de réseau (3) et un deuxième élément optique avec des deuxièmes éléments de réseau (5), qui sont disposés dans le trajet de la lumière après le système de collecteur (2) et avant le plan de champ (13).

18. Système d'éclairage selon la revendication 16 ou 17 comprenant un deuxième composant optique (7) pour éclairer un champ dans le plan de champ (13), qui est disposé dans le trajet de la lumière après le système de collecteur (2) et avant le plan de champ (13) et, si le système d'éclairage comprend un deuxième élément optique avec des deuxièmes éléments de réseau (5), après celui-ci.

19. Installation d'exposition par projection, **caractérisée en ce qu'**elle comporte un système de collecteur (2) selon l'une des revendications 1 à 15.

20. Procédé pour la fabrication de composants microélectroniques, **caractérisé en ce qu'**il utilise une installation d'exposition par projection comprenant un système de collecteur (2) selon l'une des revendications 1 à 15.
